# EUROPÄISCHE PATENTSCHRIFT

(11) **EP 2 695 974 B1**
(45) Veröffentlichungstag und Bekanntmachung des Hinweises auf die Patenterteilung: **23.12.2015**
(21) Anmeldenummer: 13177994.4
(22) Anmeldetag: 25.07.2013
(51) Int. Cl.: C30B 29/06, C01B 33/037, B02C 4/30, C22C 29/08, B02C 19/00, C01B 33/02, C30B 35/00, C22C 38/00

(54) **Verfahren zur Herstellung von polykristallinen Siliciumbruchstücken**
Method for producing polycrystalline silicon chunks
Procédé de fabrication des morceaux de silicium polycristallin

(30) Priorität: 06.08.2012 DE 102012213869
(43) Veröffentlichungstag der Anmeldung: 12.02.2014
(73) Patentinhaber: Wacker Chemie AG, 81737 München (DE)
(72) Erfinder: Wochner, Hanns Dr., 84489 Burghausen (DE); Fabry, Laszlo Dr., 84489 Burghausen (DE)
(74) Vertreter: Potten, Holger

(56) Entgegenhaltungen:
- EP-A1- 1 645 333
- EP-A1- 1 942 077
- EP-A1- 2 423 163
- WO-A1-2011/072754
- DE-A1- 10 124 393
- DE-A1-102006 035 081
- DE-A1-102007 027 110
- DE-A1-102007 039 638
- US-A1- 2006 070 569
- US-A1- 2010 098 506
- AMARTYA MUKHOPADHYAY ET AL: "Recent developments on WC-based bulk composites", JOURNAL OF MATERIALS SCIENCE, KLUWER ACADEMIC PUBLISHERS, BO, vol. 46, no. 3, 16 November 2010 (2010-11-16), pages 571-589, XP019870846, ISSN: 1573-4803, DOI: 10.1007/S10853-010-5046-7

## Beschreibung

Die Erfindung betrifft ein Verfahren zur Herstellung von polykristallinen Siliciumbruchstücken.

Polykristallines Silicium dient als Ausgangsmaterial für die Herstellung von elektronischen Bauteilen und Solarzellen.

Es wird durch thermische Zersetzung eines siliciumhaltigen Gases oder eines siliciumhaltigen Gasgemisches gewonnen. Dieser Prozess wird als Abscheidung aus der Dampfphase (CVD, chemical vapor deposition) bezeichnet. In großem Maßstab wird dieser Prozess in so genannten Siemens-Reaktoren realisiert. Das Polysilicium fällt dabei in Form von Stäben an.

Die Polysilicium-Stäbe werden aus dem Reaktor ausgebaut und mittels händischer Verfahren oder maschinell zerkleinert. Der so erhaltene Polysilicium-Grobbruch wird unter Einsatz von Brechern weiter zu polykristallinen Siliciumbruchstücken zerkleinert. Ein geeigneter Brecher, nämlich ein Walzenbrecher, ist aus US 7,950,600 B2 bekannt. Der beanspruchte Walzenbrecher umfasst eine Walze, welche sich mit einer Welle dreht, und polykristallines Silicium zerkleinert, wobei die Walze aus einer Trägerwalze aus Stahl und aus mehreren Hartmetall-Segmenten besteht, wobei die Hartmetall-Segmente aus einer Kobaltmatrix, in die Wolframcarbid eingelagert ist, bestehen und die Hartmetall-Segmente formschlüssig reversibel auf der Trägerwalze befestigt sind.

Nach dem Zerkleinern wird der Polysilicium-Bruch üblicherweise durch ein mechanisches Siebverfahren oder mittels einer optischen Sortierung sortiert bzw. klassiert.

US 2007/0235574 A1 offenbart eine Vorrichtung zum Zerkleinern und Sortieren von polykristallinem Silicium, umfassend eine Aufgabeeinrichtung für einen Polysilicium-Grobbruch in eine Brecheranlage, die Brecheranlage, und eine Sortieranlage zum Klassieren des Polysilicium-Bruchs, dadurch gekennzeichnet, dass die Vorrichtung mit einer Steuerung versehen ist, die eine variable Einstellung mindestens eines Brechparameters in der Brecheranlage und/oder mindestens eines Sortierparameters in der Sortieranlage ermöglicht.

Die Brecheranlage umfasst Walzenbrecher oder Backenbrecher, bevorzugt Stachelwalzenbrecher.

Mittels des Verfahrens ist es möglich, gezielt nicht mehr fließfähigen kubischen Polysilicium-Bruch einer Größe von 45 bis 250 mm reproduzierbar in einer hohen Ausbeute herzustellen.

Durch Verwendung von perforierten Walzen wie Stachelwalzen entsteht ein kubischer Polysiliciumbruch einer Größe von 45 bis 250 mm, wobei der Quotient aus Gewicht eines Bruchstückes und der maximalen Länge eines Bruchstückes im Mittel über alle Bruchstücke ≥ 3 g/mm ist.

US 2010/0001106 A1 offenbart ein Verfahren zur Herstellung von hochreinem klassierten Polysilicium-Bruch, bei dem ein Polysilicium aus dem Siemens-Verfahren mittels einer Vorrichtung umfassend Zerkleinerungswerkzeuge und einer Siebvorrichtung zerkleinert und klassiert wird und der so erhaltene Polysilicium-Bruch mittels eines Reinigungsbades gereinigt wird, dadurch gekennzeichnet, dass die Zerkleinerungswerkzeuge und die Siebvorrichtung durchgängig eine mit dem Polysilicium in Kontakt kommende Oberfläche aus einem Werkstoff besitzen, welches den Polysilicium-Bruch nur mit solchen Fremdpartikeln verunreinigt, welche anschließend gezielt durch das Reinigungsbad entfernt werden.

Die Zerkleinerung erfolgt in einer Brechanlage, die einen Walzenbrecher oder einen Backenbrecher, bevorzugt einen Stachelwalzenbrecher umfasst.

Vorteile verspricht dieses Verfahren insbesondere dann, wenn Zerkleinerungswerkzeuge und Siebvorrichtung eine Oberfläche aus niedriglegiertem Stahl aufweisen.

Durch Verwendung von Stachelwalzenbrechern werden kubische polykristalline Siliciumbruchstücke erhalten. Metallische Verunreinigungen können durch Verwendung von Zerkleinerungswerkzeugen aus kontaminationsarmen Werkstoffen wie Wolframcarbid auf ein niedriges Niveau abgesenkt werden.

Allerdings können kontaminationsarme Werkstoffe nicht für alle Anlagenteile - Brechschalen mit Stacheln sind explizit genannt - eingesetzt werden. Bedingt durch die hohe Sprödigkeit und die geringe Zähigkeit ist die Verwendung von abriebsarmem Wolframcarbid für perforierte Walzen eher ungeeignet.

Wird abriebsarmes Wolframcarbid verwendet, was nur bei Glattwalzen möglich sein sollte, entsteht nicht-kubischer Bruch mit erhöhten Wolframwerten, was nachteilig ist.

US 7,270,706 B2 offenbart jedoch eine perforierte Walze mit Zähnen, die um den Umfang der Walze herum angeordnet sind, eine Welle, auf der die Walze drehbar befestigt ist, ein Gehäuse mit Oberflächen, die einen Hohlraum bestimmen, innerhalb dessen die Walze angeordnet und/oder befestigt ist, einen Einlasskanal oben auf dem Gehäuse, einen Auslasskanal am Boden des Gehäuses, eine Platte innerhalb des Gehäuses gegenüber der Walze, wobei die Walze, die Zähne, die Platte und die Gehäuseoberflächen, die den Hohlraum bestimmen, hergestellt sind aus oder beschichtet sind mit einem Material, das eine Verunreinigung von polykristallinem Silicium minimiert. Das Material wird vorzugsweise ausgewählt aus der Gruppe, bestehend aus Carbiden, Kerametallen, Keramiken und Kombinationen davon. Besonders bevorzugt ist die Verwendung eines Materials ausgewählt aus der Gruppe, bestehend aus Wolframcarbid, Wolframcarbid mit einem Cobaltbinder, Wolframcarbid mit einem Nickelbinder, Titancarbid, Cr3C2, Cr3C2 mit Nickel-Chrom-Legierungsbinder, Tantalcarbid, Niobcarbid, Siliciumnitrid, Siliciumcarbid in einer Matrix, wie beispielsweise Fe, Ni, Al, Ti oder Mg, Aluminiumnitrid, Tantalcarbid, Niobcarbid, Titancarbid mit Cobalt- und Titancarbonitrid, Nickel, Nickel-Cobalt-Legierung, Eisen und Kombinationen davon.

Es hat sich gezeigt, dass bei einer perforierten Walze aus Wolframcarbid oder Wolframcarbid mit einem Cobaltbinder oder Wolframcarbid mit einem Nickelbinder keine hohe Haltbarkeit zu erreichen ist. Bereits nach der Zerkleinerung von 100 Tonnen Silicium brechen Zähne von der Walze ab. Damit muss, um weiterhin kubischen Polysiliciumbruch erzeugen zu können, ein Austausch der Walzen vorgenommen werden, was kostenintensiv und daher nachteilig ist. Es wäre wünschenswert, zumindest 1000 Tonnen Silicium zerkleinern zu können, bevor die Walze unbrauchbar wird, um eine wirtschaftliche Herstellung von kubischem polykristallinen Siliciumbruch mit kontaminationsarmem Werkzeug zu ermöglichen. US 2010/098506 A1 offenbart ein Hartmetall, umfassend eine Hartphase, die WC-Körner mit einer durchschnittlichen Korngröße von 0,3 µm oder weniger enthält; einen Binder enthaltend Co; und Co-WC-Körner mit einer mittleren Korngröße, die kleiner als diejenige der WC-Körner ist.

Werden statt Walzen aus kontaminationsarmem Material Stahlwalzen z.B. aus niedriglegiertem Stahl verwendet, resultieren erhöhte Metallkontaminationen. Daher ist eine anschließende Reinigung unverzichtbar.

Das Reinigungsverfahren nach US 2010/0001106 A1 sieht vor eine Vorreinigung in zumindest einer Stufe mit einer oxidierenden Reinigungslösung, die die Verbindungen Fluorwasserstoffsäure, Chlorwasserstoffsäure und Wasserstoffperoxid enthält, eine Hauptreinigung in einer weiteren Stufe mit einer Reinigungslösung, die Salpetersäure und Fluorwasserstoffsäure enthält, und eine Hydrophilierung des Polysilicium-Bruchs mittels einer weiteren Stufe mit einer oxidierenden Reinigungslösung

DE 10 2007 039638 A1 offenbart ein Verfahren zur Reinigung von Polysilicium umfassend die Schritte
a.) Vorreinigung in zumindest einer Stufe mit einer oxidierenden Reinigungslösung, enthaltend ein oder mehrere Verbindungen aus der Gruppe Fluorwasserstoffsäure, Chlorwasserstoffsäure, Salpetersäure, Hexafluorokieselsäure und Wasserstoffperoxid,
b.) Hauptreinigung in einer weiteren Stufe mit einer Reinigungslösung, enthaltend ein oder mehrere Verbindungen aus der Gruppe Salpetersäure, Fluorwasserstoffsäure und Hexafluorokieselsäure,
c.) Nachreinigung in einer weiteren Stufe mit einer Reinigungslösung enthaltend Fluorwasserstoffsäure und Ozon,
d.) Hydrophilierung in einer weiteren Stufe mit einer oxidierenden Reinigungslösung.

EP 1 942 077 A1 offenbart ein Verfahren zum Recyclen von Siliciumschrott durch Schmelzen des Siliciums, gerichtete Erstarrung der Schmelze zu einem Stab und Entfernen eines verunreigten teils vom Stab. Siliciumschrott kann z.B. beim Zersägen von Silicium anfallen. In einer Ausführungsform wird der Siliciumschrott mit sauren und/oder alkalischen Medien gereinigt.

Auch US 7,270,706 B2 schlägt entsprechende optionale Reinigungsverfahren vor.

Durch solche Reinigungsverfahren können die Metallkontaminationen an der Oberfläche reduziert werden.

Allerdings sind nicht alle Metalle in den verwendeten Mineralsäuren gut löslich. Es hat sich gezeigt, dass Wolfram - bei Verwendung von Wolframcarbid als Walzenmaterial wird das Material mit Wolfram kontaminiert - sich nicht in befriedigender Weise entfernen lässt, was daran liegt, dass Wolfram in den Mineralsäuren nicht gut löslich ist.

Aus dieser Problematik ergab sich eine erste Aufgabenstellung der Erfindung. Ein weiteres Ziel ist es, gegenüber den bestehenden Verfahren die Beschaffungskosten für die Reinigungsanlage um 25 % und die Säure und Entsorgungskosten ebenfalls um 25 % zu senken.

DE 10 2007 027110 A1 offenbart ein Verfahren zur Verpackung von polykristallinem Silicium, bei dem polykristallines Silicium mittels einer Abfüllvorrichtung in einen frei hängenden, fertig geformten Beutel gefüllt wird, wobei der gefüllte Beutel anschliessend verschlossen wird, dadurch gekennzeichnet, dass der Beutel aus hochreinem Kunststoff mit einer Wanddicke von 10 bis 1000 [mu]m besteht.

EP 2 423 163 A1 offenbart ein Verfahren zur Herstellung von polykristallinem Silicium nach einem der Ansprüche 1 bis 6, umfassend Brechen von an Dünnstäben in einem Siemensreaktor abgeschiedenem polykristallinem Silicium in Bruchstücke, Klassieren der Bruchstücke in Größenklassen von etwa 0,5 mm bis größer als 45 mm und Behandlung der Bruchstücke mittels Druckluft oder Trockeneis, um Siliciumstaub von den Bruchstücken zu entfernen, wobei keine chemische Nassreinigung erfolgt.

Die Kubizität von polykristallinen Siliciumbruchstücken wird nach DIN EN 933-4 bestimmt. Hierbei wird mit einem Kornform-Messschieber das Länge-zu-Dicken Verhältnis des Korngutes bestimmt.

Kubischer Bruch ist wie folgt definiert:
Länge/Dicke > 3 ist ein nicht kubischer Bruch.
Länge/Dicke < 3 ist ein kubischer Bruch.

In anderen Worten muss für kubischen Bruch das Verhältnis zwischen der längsten und kürzesten Abmessung eines Bruchstücks kleiner als 3 sein.

Beim Einrichten eines Tiegels mit Polybruch beeinflusst die Kubizität des Polybruchs die Menge, die in einen Tiegel eingerichtet werden kann. Mit einem kubischen Bruch können ca. 5 bis 10 % mehr Menge eingerichtet werden, was vorteilhaft ist.

Die Aufgabe der Erfindung wird gelöst durch ein Verfahren zur Herstellung von polykristallinen Siliciumbruchstücken, umfassend Bereitstellen eines polykristallinen Siliciumstabs, Zerkleinerung des polykristallinen Siliciumstabs in kubische Bruchstücke, Reinigung der polykristallinen Siliciumbruchstücke, dadurch gekennzeichnet, dass zur Zerkleinerung ein Stachelwalzenbrecher mit wenigstens einer Stachelwalze eingesetzt wird, wobei die wenigstens eine Stachelwalze auf W₂C-Phasen basiert.

Ein solcher Stachelwalzenbrecher weist eine geringe Sprödigkeit und eine hohe Zähigkeit auf. Das Material ist nicht abriebsarm, so dass es beim Zerkleinern zu einer Kontamination des Siliciums kommt. Es hat sich jedoch gezeigt, dass die Kontaminationen gut abgereinigt werden können.

Diese Eigenschaften weisen auch Stachelwalzen aus Stahl auf, wenn 1-25% W im Stahl enthalten sind.

Durch den Einsatz von Stachelwalzen führt das erfindungsgemäße Verfahren zu einem kubischen Polysiliciumbruch.

Im Folgenden wird eine bevorzugte Ausführungsform des erfindungsgemäßen Verfahrens im Detail erläutert.

Ein Polysiliziumstab wird mit Zerkleinerungsmaschinen auf der Basis von nicht spröden und in Mineralsäuren löslichen WC-Sorten zerkleinert.

Die nicht spröden WC-Sorten ermöglichen die Verwendung von Stachelwalzen und damit die Erzeugung eines kubischen Polybruchs.

Ein auf diesem Weg erzeugter Polybruch hat einen Eingangspegel bezüglich Eisen und Wolfram von < 10 ppbw.

Die nicht spröden WC-Sorten basieren auf W₂C-Phasen.

Wolframcarbid auf der Basis von W2C- Phasen ist in HF/HNO3 löslich.

Als Bindemittel wird vorzugsweise Cobalt verwendet mit einem Anteil von 0,1 bis maximal 20 %.

Vorzugsweise umfasst die Stachelwalze 80-99,9% W₂C und 0,1-20% Cobalt.

Auch die Korngröße der W₂C-Partikel hat einen Einfluss auf den Abrieb und die Säurelöslichkeit. Aus der Publikation "Recent developments on WC-based bulk composites", Journal of materials science JMS 46: 571-589 (2011) ist bekannt, dass eine Reduktion der Korngröße zu einer höheren Vickers-Härte des Wolframcarbids bei Raumtemperatur führt. Damit sind Stachelwalzen mit kleinen Korngrößen tendenziell abriebsärmer. Allerdings verschlechtert sich die Säurelöslichkeit bei reduzierten Korngrößen. Es handelt sich um gegenläufige Effekte. Im Rahmen dieser Erfindung wird ein erhöhter Abrieb in Kauf genommen, da sich gezeigt hat, dass sich die verwendeten Wolframcarbid-Typen (W2C) gut entfernen lassen.

Bei der Reinigung wird vorzugsweise wie folgt vorgegangen:
Die Vorreinigung und die Hauptreinigung erfolgen in separaten Säurekreisen Vorreinigung in HF, HCl und H2O2, z.B. für 5 Minuten in einer Mischung aus HF 5 Gew. %, HCL 8 Gew. %, H2O2 3 Gew. % bei einer Temperatur von 22 °C und einem Materialabtrag von 0,02 µm

Spülen mit Reinstwasser (z.B. 18 MΩ für 5 Minuten bei 22 °C).

Hauptreinigung mittels HF/HNO3, z.B. : Ätzen für 2 Min bei 8 °C in HF/HN03 mit 6 Gew.% HF, 55 Gew.% HNO3 und 1 Gew.% Si; Ätzabtrag: ca. 30 µm

Spülen mit Reinstwasser, z.B. mit 22°C warmem Reinstwasser mit 18 MΩ für 5 Min Hydrophilierung mit Ozonwasser, z.B für 5 Min in 22 °C warmem Wasser, das mit 20 ppm Ozon gesättigt ist

Trocknen mit Reinstluft, z.B. 60 Min Trocknen mit Reinstluft der Klasse 100 bei 80 °C Abkühlen mit Reinstluft, z.B. auf 22 °C

Beim Trocknen und beim Abkühlen wird die Luft vorzugsweise mittels bor-freier PTFE-Filter gereinigt.

Die gereinigten Polysiliciumbruchstücke werden anschließend in einen PE-Beutel verpackt. Dazu wird vorzugsweise ein dotierstoffarmer PE-Handschuh verwendet. Alle verwendeten Kunststoffe haben einen Bor-, Phosphor- und Arsengehalt von kleiner als 10 ppbw.

Die verwendeten Mineralsäuren HCl, HF und HNO3 dürfen maximal enthalten
- B: 10 ppbw;
- P: 500 ppbw
- As: 50 ppbw.

Es hat sich gezeigt, dass mit einer Stachelwalze gemäß erfindungsgemäßen Verfahren eine höhere Haltbarkeit erreicht wird.

Es können stets mehr als 1000 Tonnen Silicium zerkleinert werden, bevor einzelne Zähne aus der Stachelwalze herausbrechen.

Beim erfindungsgemäßen Verfahren und der beschriebenen Ausführungsform wird vorzugsweise sichergestellt, dass sich der Brecher in einem Reinraum der Klasse kleiner oder gleich 10000 befindet.

Vorzugsweise befindet sich die Anlage in einem Reinraum der Klasse 100 oder besser(nach US FED STD 209E, abgelöst durch ISO 14644-1).

Bei Klasse 100 (ISO 5) dürfen max. 3,5 Partikel von max. 0,5 µm Durchmesser pro Liter enthalten sein.

Im Reinraum werden vorzugsweise ausschließlich Reinraumfilter mit einer PTFE-Membran verwendet.

Der Reinraumfilter sollte wie folgt aufgebaut sein:
Er umfasst einen nicht-verziehbaren Rahmen, der wenig Partikel abgibt, vorzugsweise aus Holz, z.B. Sperrholz, oder aus Aluminium.

Der Filter umfasst weiterhin ein Stützgewebe, das aus drei Schichten besteht. Eine obere und eine untere Schicht bestehen aus PE + PET. Bei der mittleren Schicht handelt es sich um PTFE.

Es ist sicherzustellen, dass die Hilfsstoffe (u.a. der Kleber, Vergussmassen, Rahmenteile, Stützgewebe und PTFE-Membran), die im Filter verwendet werden, weniger als 10 ppbw Bor, weniger als 10 ppbw Phosphor und weniger als 10 ppbw Arsen enthalten.

Das Stützgewebe ist vorzugsweise mit dem Rahmen verklebt.

Beim Kleber handelt es sich vorzugsweise um Polyvinylacetat.

Vorzugsweise ist im Reinraum ein Ionisationssystem implementiert, um durch aktive Luftionisation elektrostatische Ladungen zu neutralisieren. Ionisatoren durchsetzen die Reinraumluft derart mit Ionen, dass statische Ladungen an Isolatoren und ungeerdeten Leitern abgebaut werden.

Zum Auskleiden von Metallteilen am Brecher wird wenigstens ein Kunststoff, ausgewählt aus einem oder mehreren Elementen der Gruppe bestehend aus Polypropylen, Polyethylen, PU und PVDF, verwendet, wobei die Auskleidung des Brechers weniger als 100 ppbw Bor, weniger als 100 ppbw Phosphor und weniger als 10 ppbw Arsen enthält.

Nach dem Zerkleinern wird das gebrochene Silicium vorzugsweise mittels eines mechanischen Siebs in Bruchgrößen klassifiziert, wobei das mechanische Sieb mit Kunststoff oder mit Silicium ausgekleidet ist. Der verwendete Kunststoff enthält weniger als 10 ppbw an B, P und As. Der dabei verwendete Kunststoff wird ausgewählt aus einem oder mehreren Elementen der Gruppe bestehend aus Polypropylen, Polyethylen, PU und Polyvinylidenfluorid (PVDF).

Die Reinigungsanlage befindet sich vorzugsweise in einem Reinraum der Klasse kleiner oder gleich 10000, vorzugsweise in einem Reinraum der Klasse 100 oder besser.

Im Reinraum werden ausschließlich Reinraumfilter mit einer PTFE-Membran verwendet.

Zum Auskleiden von Ätzbecken und Rohrleitungen wird vorzugsweise wenigstens ein Kunststoff, ausgewählt aus einem oder mehreren Elementen der Gruppe bestehend aus Polypropylen, Polyethylen, PU und PVDF verwendet, der weniger als 100 ppbw Bor, zudem weniger als 100 ppbw Phosphor und vorzugsweise auch weniger als 10 ppbw Arsen enthält.

Bei den im Reinigungsverfahren verwendeten Säuren wie z.B. HF, HCl und HNO3 ist darauf zu achten, dass diese weniger als 10 ppbw Bor und zudem weniger als 500 ppbw Phosphor enthalten.

Vorzugsweise enthalten die Säuren weniger als 50 ppbw Arsen.

Um die Verwendung dotierstoffarmer Säuren sicherzustellen, werden die Dotierstoffgehalte der Säuren von Vor- und Hauptreinigung und Hydrophilierung diesbezüglich überwacht. Dazu wird vor jedem der Reinigungsvorgänge der Bor-, Phosphor- und Arsen-Gehalt überprüft. Falls die o.g. Werte überschritten werden, werden die Säuren ausgetauscht oder frische Säure in die Reinigungsbecken zudosiert, um sicherzustellen, dass weniger als 10 ppbw Bor und weniger als 500 ppbw Phosphor in den Säuren enthalten sind.

Während des Zerkleinerns des Polybruchs wird vorzugsweise folgende Schutzkleidung getragen:
a.) Schutzbrille gegen Si-Splitter (Augenschutz)
b.) Eine Weste, um den Bauch- und Hals-Bereich zu schützen; bestehend aus einem stich- und schnittfesten Gewebe z.B. aus Keflar® mit Dyneema® oder Stahl- Fasern ("Keflar" ist eine geschützte Marke von DuPont, "Dyneema" ist eine geschützte Marke von DSM)
c.) Zum Schutz vor Stich und Schnittverletzungen werden entsprechende Handschuhe getragen, z.B. ein Kombination aus einem stich- und schnittfesten Unterziehhandschuh (bevorzugt PU- Dynneema® oder Keflar® mit Stahldrähten) und ein Überziehhandschuh z.B. ein kombinierter Baumwoll/Polyester-Handschuh mit gefärbter oder nicht gefärbter Baumwollfaser innen und einer Polyesterfaser außen

### Beispiele

### Beispiel 1

In einer Vortestung wurde ein 0,5 g schweres WC-Stück mit Cobaltbinder 10 % (W₂C-Phase oder WC Phase mit 3 % Nickelcarbid oder 5 % Chromcarbid) für 10 Minuten in einer HF/HN03-Mischung mit 6 Gew. % HF, 55 Gew. % HNO3 und 1 Gew. % Si gelegt. Nach den 10 Minuten war das Stück vollständig aufgelöst.

Dies zeigt, dass sich die verwendeten W2C-Phasen auch in Mineralsäuren sehr gut lösen, was für das erfindungsgemäße Verfahren essentiell ist.

Ein 100 kg schwerer Stab wurde über eine Stachelwalze aus in Mineralsäuren löslichem WC zerkleinert. Verwendet wurde ein WC mit 10 % Co und 5 % Chromcarbid.

Zehn 100 g schwere Polybruchstücke wurden mit folgendem Prozess in einer Prozessschale gereinigt:
1. Vorreinigung in Beize
   2 Min Reinigen in einer Mischung aus HF 5 Gew. %, HCl 8 Gew. % und H2O2 3 Gew. % bei einer Temperatur von 22 °C. Der Abtrag betrug 0,02 µm.
2. Spülen mit Reinstwasser 18 MΩ für 5 Minuten bei 22 °C.
3. Hauptreinigung: Ätzen für 2 Min bei 8 °C in HF/HNO3 mit 6 Gew.% HF, 55 Gew.% HNO3 und 1 Gew.% Si Der Ätzabtrag betrug ca. 30 µm.
4. 5 Min Spülen mit 22 °C warmen Reinstwasser mit 18 MΩ
5. 2 Min Hydrophilierung in 22 °C warmem Wasser, das mit 20 ppm Ozon gesättigt war.
6. 60 Min Trocknen mit Reinstluft der Klasse 100 bei 80 °C mit Borfreien Teflonfilter
7. Abkühlen mit Reinstluft bei 22 °C mit Borfreien Teflonfilter

Anschließend wurden die polykristallinen Siliciumbruchstücke unter Verwendung von PE-Handschuhen in PE-Beutel verpackt.

Alle verwendeten Kunststoffe hatten einen Bor-, Phosphor- und Arsengehalt in Summe von kleiner als 10 ppbw.

Die verwendeten Mineralsäuren HCl, HF und Salpetersäuren enthielten jeweils maximal
- B: 10 ppbw;
- P: 500 ppbw;
- As: 50 ppbw

**Tabelle 1** zeigt Metalloberflächenwerte vor der Reinigung (Eingangswerte); Angaben in pptw.

**Tabelle 2** zeigt Metallwerte nach der Reinigung; Angaben in pptw

Es zeigt sich, dass bei der Reinigung alle Metallwerte incl. Wolfram deutlich gesenkt werden. Dies war nur dadurch zu bewerkstelligen, dass beim Zerkleinern Walzen mit in Mineralsäuren löslichem Wolfram oder Wolframcarbid verwendet wurden.

### Beispiel 2

In einer Vortestung wurde ein 0,5 g schweres Stahlstück mit einem Wolframgehalt von 15 Gew. % (Böhler Stahl) in eine HF/HNO₃-Mischung mit 6 Gew. % HF, 55 Gew. % HNO3 und 1 Gew. % Si gelegt für 10 Minuten. Nach den 10 Minuten war das Stück vollständig aufgelöst.

Ein 100 kg schwerer Stab wurde über eine Stachelwalze aus einer in Mineralsäuren löslichen Stahlsorte mit 15 Gew. % W zerkleinert.

Zehn 100 g schwere Polybruchstücke wurden mit folgendem Prozess in einer Prozessschale gereinigt:
1. Vorreinigung in Beize
   2 Min Reinigen in einer Mischung aus HF 5 Gew. %, HCl 8 Gew. % und H2O2 3 Gew. % bei einer Temperatur von 22 °C. Der Abtrag betrug 0,02 µm.
2. Spülen mit Reinstwasser 18 MΩ für 5 Minuten bei 22 °C.
3. Hauptreinigung: Ätzen für 2 Min bei 8 °C in HF/HN03 mit 6 Gew. % HF, 55 Gew.% HNO3 und 1 Gew.% Si Der Ätzabtrag betrug ca. 30 µm.
4. 5 Min Spülen mit 22 °C warmen Reinstwasser mit 18 MΩ
5. 2 Min Hydrophilierung in 22 °C warmem Wasser, das mit 20 ppm Ozon gesättigt war.
6. 60 Min Trocknen mit Reinstluft der Klasse 100 bei 80 °C mit Borfreien Teflonfilter
7. Abkühlen mit Reinstluft bei 22 °C mit Borfreien Teflonfilter

Anschließend wurden die polykristallinen Siliciumbruchstücke unter Verwendung von PE-Handschuhen in PE-Beutel verpackt.

Alle verwendeten Kunststoffe hatten einen Bor-, Phosphor- und Arsengehalt in Summe von kleiner als 10 ppbw.

Die verwendeten Mineralsäuren HCl, HF und Salpetersäuren enthielten jeweils maximal
- B: 10 ppbw;
- P: 500 ppbw;
- As: 50 ppbw.

**Tabelle 3** zeigt Metalloberflächenwerte vor der Reinigung ( Eingangswerte ); Angaben in pptw

**Tabelle 4** zeigt Metallwerte nach der Reinigung; Angaben in pptw

Es zeigt sich, dass bei der Reinigung alle Metallwerte incl. Wolfram deutlich gesenkt werden. Dies war nur dadurch zu bewerkstelligen, dass beim Zerkleinern Walzen mit in Mineralsäuren löslichem Wolfram oder Wolframcarbid verwendet wurden.

### Beispiel 3

In einer Vortestung wurde ein 0,5 g schweres Stahlstück mit einem Wolframgehalt von 10 Gew. % ( Böhler Stahl ) für 10 Minuten in eine 60 Grad warme 20 Gew. % Kalilauge gelegt. Nach den 10 Minuten war das Stück vollständig aufgelöst.

Ein 100 kg schwerer Stab wurde über eine Stachelwalze aus einer in alkalischen Medien löslichen Stahlsorte mit 10 Gew. % W zerkleinert.

Zehn 100 g schwere Polybruchstücke wurden mit folgendem Prozess in einer Prozessschale gereinigt:
1. Vorreinigung in einer Kalilauge
   2 Min Reinigen in einer Mischung aus 20 Gew. % KOH bei einer Temperatur von 60 °C.
      Abtrag: 2 µm
2. Spülen mit Reinstwasser 18 MΩ für 5 Minuten bei 22 °C
3. Hauptreinigung: Ätzen für 5 Min bei 8 °C in HF/HN03 mit 6 Gew.% HF, 55 Gew.% HNO3 und 1 Gew.% Si
   Ätzabtrag: ca. 30 µm
4. 5 Min Spülen mit 22 °C warmen Reinstwasser mit 18 MΩ
5. 5 Min Hydrophilierung in 22 °C warmem Wasser, das mit 20 ppm Ozon gesättigt war
6. 60 Min Trocknen mit Reinstluft der Klasse 100 bei 80 °C mit Borfreien Teflonfilter
7. Abkühlen mit Reinstluft (22 °C) mit Borfreien Teflonfilter

Anschließend wurden die polykristallinen Siliciumbruchstücke unter Verwendung von PE-Handschuhen in PE-Beutel verpackt.

Alle verwendeten Kunststoffe hatten einen Bor-, Phosphor- und Arsengehalt in Summe von kleiner als 10 ppbw.

Die verwendeten Mineralsäuren HCl, HF und Salpetersäuren enthielten jeweils maximal
- B: 10 ppbw;
- P: 500 ppbw;
- As: 50 ppbw.

**Tabelle 5** zeigt Metalloberflächenwerte vor der Reinigung (Eingangswerte); Angaben in pptw

**Tabelle 6** zeigt Metallwerte nach der Reinigung; Angaben in pptw.

Es zeigt sich, dass bei der Reinigung alle Metallwerte incl. Wolfram deutlich gesenkt werden. Dies war nur dadurch zu bewerkstelligen, dass beim Zerkleinern Walzen mit in alkalischen Medien löslichem Wolfram oder Wolframcarbid verwendet wurden.

**Tabelle 7** zeigt Dotierstoffkonzentrationen an der Oberfläche der nach den Beispielen 1 bis 3 zerkleinerten und gereinigten Polysiliciumbruchstücke. Von den jeweils 10 gereinigten Bruchstücken wurden jeweils 5 auf Dotierstoffe untersucht. Proben #1-#5 entsprechen Beispiel 1, Proben #6-#10 Beispiel 2 und Proben #11-#15 Beispiel 3.

**Tabelle 7**

| | B in ppta | P in ppta | As in ppta |
|---|---|---|---|
| #1 | 13 | 1 | 2 |
| #2 | 18 | 3 | 3 |
| #3 | 17 | 7 | < 0,1 |
| #4 | 16 | 5 | 0,2 |
| #5 | 3 | 6 | < 0,1 |
| #6 | 3 | 8 | 5 |
| #7 | 12 | 8 | 2 |
| #8 | 7 | 9 | < 0,1 |
| #9 | 5 | 16 | 3 |
| #10 | 17 | 4 | 3 |
| #11 | 14 | 8 | 2 |
| #12 | 7 | 14 | 5 |
| #13 | 2 | < 1 | < 0,1 |
| #14 | 3 | 3 | 1 |
| #15 | 2 | 14 | 3 |

**Tabelle 8** zeigt einen Vergleich der spezifischen Anlagenkosten pro Jahrestonne Polysilicium.

**Tabelle 8**

| Verfahren | Kosten/ EUR |
|---|---|
| Stand der Technik US 2010/0001106 A1 | 2000 |
| Weg 1 Stachelwalze mit W2C-Phase Vorreinigung mit Mineralsäuren | 1500 |
| Weg 2 Stachelwalze aus Stahl mit 15% W Vorreinigung mit Mineralsäuren | 1600 |
| Weg 3 Stachelwalze aus Stahl mit 10% W Alkalische Vorreinigung | 1300 |

**Tabelle 9** zeigt einen Vergleich der spezifischen Säurekosten pro kg Polysilicium.

**Tabelle 9**

| Verfahren | Kosten/ EUR |
|---|---|
| Stand der Technik US 2010/0001106 A1 | 0,45 |
| Weg 1 Stachelwalze mit W2C-Phase Vorreinigung mit Mineralsäuren | 0,3 |
| Weg 2 Stachelwalze aus Stahl mit 15% W Vorreinigung mit Mineralsäuren | 0,33 |
| Weg 3 Stachelwalze aus Stahl mit 10% W Alkalische Vorreinigung | 0,24 |

Daher ist die Verwendung von Stachelwalzen enthaltend Wolframcarbid zum Zerkleinern und anschließender alkalischer Vorreinigung ganz besonders bevorzugt.

**Tabelle 10** zeigt einen Vergleich der spezifischen Materialkosten für das Beschaffen von Stachelwalzen pro Jahrestonne Polysilicium.

**Tabelle 10**

| Verfahren | **Kosten in EUR** |
|---|---|
| Stahlwalzen (US 2010/0001106 A1) | 20 |
| Walzen aus spröden, nicht säurelöslichen WC-Sorten (US 7,270,706 B2) | 2500 |
| Walzen aus nicht spröden, säurelöslichen WC-Sorten (W2C) | 250 |
| Stahlwalzen mit 1-25 % W | 20 |

Die Walzen mit den nicht-spröden WC-Sorten (W2C oder WC mit Zusätzen) sind deutlich günstiger als Walzen aus sprödem WC (ohne Zusätze oder aus W2C-Phasen).

**Tabelle 1**

| **Zu Beispiel 1, Metallkontaminationen vor der Reinigung, Angaben in pptw** | | | | | | | | | | | | | | | | | |
|---|---|---|---|---|---|---|---|---|---|---|---|---|---|---|---|---|---|
| | **Fe** | **Cr** | **Ni** | **Na** | **Zn** | **Al** | **Cu** | **Mo** | **Ti** | **W** | **K** | **Co** | **Mn** | **Ca** | **Mg** | **V** | **Ag** |
| | 2000 | 20 | 1 | 185 | 145 | 88 | 1 | 0 | 210 | 6000 | 188 | 45 | 0 | 210 | 45 | 0 | 0 |
| | 2500 | 15 | 0 | 155 | 122 | 120 | 0 | 0 | 220 | 5000 | 123 | 55 | 0 | 156 | 56 | 2 | 2 |
| | 1200 | 10 | 1 | 135 | 166 | 134 | 1 | 1 | 190 | 5550 | 134 | 67 | 1 | 145 | 67 | 3 | 0 |
| | 800 | 5 | 2 | 210 | 177 | 187 | 0 | 0 | 234 | 4976 | 165 | 110 | 0 | 122 | 23 | 1 | 0 |
| | 5000 | 23 | 0 | 110 | 123 | 145 | 2 | 0 | 250 | 7230 | 210 | 56 | 2 | 234 | 45 | 1 | 2 |
| | 4350 | 22 | 1 | 165 | 169 | 110 | 1 | 0 | 123 | 8250 | 67 | 134 | 1 | 125 | 21 | 2 | 0 |
| | 1240 | 17 | 2 | 235 | 135 | 89 | 1 | 0 | 210 | 2100 | 145 | 120 | 1 | 210 | 48 | 3 | 1 |
| | 6700 | 19 | 3 | 189 | 189 | 210 | 3 | 0 | 230 | 3500 | 167 | 89 | 0 | 267 | 66 | 1 | 2 |
| 25% Quantil | 1230 | 14 | 1 | 129 | 132 | 105 | 1 | 0 | 205 | 4532 | 131 | 56 | 0 | 140 | 40 | 1 | 0 |
| Median | 2250 | 18 | 1 | 160 | 156 | 127 | 1 | 0 | 215 | 5275 | 155 | 78 | 1 | 183 | 47 | 2 | 1 |
| Mittelwert | 2974 | 16 | 1 | 163 | 153 | 135 | 1 | 0 | 208 | 5313 | 150 | 85 | 1 | 184 | 46 | 2 | 1 |
| 75% Quantil | 4513 | 21 | 2 | 191 | 171 | 156 | 1 | 0 | 231 | 6308 | 172 | 113 | 1 | 216 | 59 | 2 | 2 |

**Tabelle 2**

| **Zu Beispiel 1, Metallkontaminationen nach der Reinigung, Angaben in pptw** | | | | | | | | | | | | | | | | | |
|---|---|---|---|---|---|---|---|---|---|---|---|---|---|---|---|---|---|
| | **Fe** | **Cr** | **Ni** | **Na** | **Zn** | **Al** | **Cu** | **Mo** | **Ti** | **W** | **K** | **Co** | **Mn** | **Ca** | **Mg** | **V** | **Ag** |
| | 20 | 2 | 1 | 2 | 0 | 1 | 1 | 0 | 12 | 1 | 1 | 0 | 0 | 12 | 0 | 0 | 0 |
| | 5 | 1 | 0 | 4 | 1 | 3 | 0 | 0 | 15 | 2 | 3 | 1 | 0 | 9 | 1 | 0 | 0 |
| | 2 | 0 | 1 | 7 | 3 | 2 | 1 | 1 | 5 | 0 | 1 | 2 | 1 | 3 | 1 | 1 | 0 |
| | 12 | 1 | 2 | 1 | 2 | 1 | 0 | 0 | 2 | 0 | 2 | 0 | 0 | 12 | 2 | 0 | 0 |
| | 9 | 2 | 0 | 3 | 1 | 0 | 2 | 0 | 5 | 1 | 1 | 0 | 2 | 6 | 0 | 0 | 0 |
| | 7 | 0 | 1 | 4 | 2 | 1 | 1 | 0 | 9 | 2 | 3 | 1 | 1 | 3 | 1 | 10 | |
| | 4 | 1 | 2 | 2 | 1 | 2 | 1 | 0 | 12 | 2 | 0 | 0 | 1 | 1 | 2 | 0 | 0 |
| | 9 | 2 | 3 | 1 | 2 | 1 | 3 | 0 | 14 | 1 | 1 | 1 | 0 | 2 | 1 | 1 | 2 |
| 25% Quantil | 5 | 1 | 1 | 2 | 1 | 1 | 1 | 0 | 5 | 1 | 1 | 0 | 0 | 3 | 1 | 0 | 0 |
| Median | 8 | 1 | 1 | 3 | 2 | 1 | 1 | 0 | 11 | 1 | 1 | 1 | 1 | 5 | 1 | 0 | 0 |
| Mittelwert | 9 | 1 | 1 | 3 | 2 | 1 | 1 | 0 | 9 | 1 | 2 | 1 | 1 | 6 | 1 | 0 | 0 |
| 75% Quantil | 10 | 2 | 2 | 4 | 2 | 2 | 1 | 0 | 13 | 2 | 2 | 1 | 1 | 10 | 1 | 1 | 0 |

**Tabelle 3**

| **Zu Beispiel 2, Metallkontaminationen vor der Reinigung, Angaben in pptw** | | | | | | | | | | | | | | | | | |
|---|---|---|---|---|---|---|---|---|---|---|---|---|---|---|---|---|---|
| | **Fe** | **Cr** | **Ni** | **Na** | **Zn** | **Al** | **Cu** | **Mo** | **Ti** | **W** | **K** | **Co** | **Mn** | **Ca** | **Mg** | **V** | **Ag** |
| | 800 | 20 | 2 | 185 | 145 | 88 | 3 | 1 | 210 | 499 | 188 | 15 | 2 | 210 | 45 | 0 | 0 |
| | 7500 | 15 | 4 | 155 | 122 | 120 | 4 | 2 | 220 | 323 | 123 | 23 | 4 | 156 | 56 | 2 | 2 |
| | 9500 | 10 | 5 | 135 | 166 | 134 | 2 | 1 | 190 | 750 | 134 | 25 | 2 | 146 | 67 | 3 | 0 |
| | 6000 | 5 | 2 | 210 | 177 | 187 | 6 | 0 | 234 | 230 | 165 | 11 | 0 | 122 | 23 | 1 | 0 |
| | 7000 | 23 | 1 | 110 | 123 | 145 | 4 | 2 | 250 | 340 | 210 | 50 | 1 | 234 | 45 | 1 | 2 |
| | 8850 | 22 | 5 | 165 | 169 | 110 | 2 | 0 | 123 | 710 | 67 | 13 | 5 | 125 | 21 | 2 | 0 |
| | 7550 | 17 | 2 | 235 | 135 | 89 | 1 | 3 | 210 | 145 | 145 | 12 | 0 | 210 | 48 | 3 | 1 |
| | 6700 | 19 | 3 | 110 | 189 | 210 | 3 | 0 | 230 | 167 | 167 | 14 | 1 | 267 | 66 | 1 | 2 |
| 25% Quantil | 6625 | 14 | 2 | 129 | 132 | 105 | 2 | 0 | 205 | 131 | 131 | 13 | 1 | 140 | 40 | 1 | 0 |
| Median | 7250 | 18 | 3 | 160 | 156 | 127 | 3 | 1 | 215 | 155 | 156 | 15 | 2 | 183 | 47 | 2 | 1 |
| Mittelwert | 6738 | 16 | 3 | 163 | 153 | 135 | 3 | 1 | 208 | 150 | 150 | 20 | 2 | 184 | 46 | 2 | 1 |
| 75% Quantil | 7875 | 21 | 4 | 191 | 171 | 156 | 4 | 2 | 231 | 172 | 172 | 24 | 3 | 216 | 59 | 2 | 2 |

**Tabelle 4**

| **Zu Beispiel 2, Metallkontaminationen nach der Reinigung, Angaben in pptw** | | | | | | | | | | | | | | | | | |
|---|---|---|---|---|---|---|---|---|---|---|---|---|---|---|---|---|---|
| | **Fe** | **Cr** | **Ni** | **Na** | **Zn** | **Al** | **Cu** | **Mo** | **Ti** | **W** | **K** | **Co** | **Mn** | **Ca** | **Mg** | **V** | **Ag** |
| | 12 | 2 | 1 | 2 | 0 | 1 | 1 | 0 | 12 | 1 | 1 | 0 | 0 | 12 | 0 | 0 | 0 |
| | 3 | 1 | 0 | 4 | 1 | 3 | 0 | 0 | 15 | 2 | 3 | 1 | 0 | 9 | 1 | 0 | 0 |
| | 2 | 0 | 1 | 7 | 3 | 2 | 1 | 1 | 5 | 0 | 1 | 2 | 1 | 3 | 1 | 1 | 0 |
| | 9 | 1 | 2 | 1 | 2 | 1 | 0 | 0 | 2 | 0 | 2 | 0 | 0 | 12 | 2 | 0 | 0 |
| | 8 | 2 | 0 | 3 | 1 | 0 | 2 | 0 | 5 | 1 | 1 | 0 | 2 | 6 | 0 | 0 | 0 |
| | 6 | 0 | 1 | 4 | 2 | 1 | 1 | 0 | 9 | 2 | 3 | 1 | 1 | 3 | 1 | 1 | 0 |
| | 4 | 1 | 2 | 2 | 1 | 2 | 1 | 0 | 12 | 2 | 0 | 0 | 1 | 1 | 2 | 0 | 0 |
| | 9 | 2 | 3 | 1 | 2 | 1 | 3 | 0 | 14 | 1 | 1 | 1 | 0 | 2 | 1 | 1 | 2 |
| 25% Quantil | 4 | 1 | 1 | 2 | 1 | 1 | 1 | 0 | 5 | 1 | 1 | 0 | 0 | 3 | 1 | 0 | 0 |
| Median | 7 | 1 | 1 | 3 | 2 | 1 | 1 | 0 | 11 | 1 | 1 | 1 | 1 | 5 | 1 | 0 | 0 |
| Mittelwert | 7 | 1 | 1 | 3 | 2 | 1 | 1 | 0 | 9 | 1 | 2 | 1 | 1 | 6 | 1 | 0 | 0 |
| 75% Quantil | 9 | 2 | 2 | 4 | 2 | 2 | 1 | 0 | 13 | 2 | 2 | 1 | 1 | 10 | 1 | 1 | 0 |

**Tabelle 5**

| **Zu Beispiel 3, Metallkontaminationen vor der Reinigung, Angaben in pptw** | | | | | | | | | | | | | | | | |
|---|---|---|---|---|---|---|---|---|---|---|---|---|---|---|---|---|
| | **Fe** | **Cr** | **Ni** | **Na** | **Zn** | **Al** | **Cu** | **Mo** | **Ti** | **W** | **K** | **Co** | **Mn** | **Ca** | **Mg** | **V** |
| | 9000 | 20 | 2 | 185 | 145 | 88 | 3 | 1 | 210 | 400 | 188 | 15 | 2 | 210 | 45 | 0 |
| | 8550 | 15 | 4 | 155 | 122 | 120 | 4 | 2 | 220 | 250 | 123 | 12 | 4 | 156 | 56 | 2 |
| | 4550 | 10 | 5 | 135 | 166 | 134 | 2 | 1 | 190 | 450 | 134 | 24 | 2 | 145 | 67 | 3 |
| | 2300 | 5 | 2 | 210 | 177 | 187 | 6 | 0 | 234 | 350 | 165 | 45 | 0 | 122 | 23 | 1 |
| | 6700 | 23 | 1 | 110 | 123 | 145 | 4 | 2 | 250 | 340 | 210 | 55 | 1 | 234 | 45 | 1 |
| | 4502 | 22 | 5 | 165 | 169 | 110 | 2 | 0 | 123 | 125 | 67 | 9 | 5 | 125 | 21 | 2 |
| | 4360 | 17 | 2 | 235 | 135 | 89 | 1 | 3 | 210 | 465 | 145 | 13 | 0 | 210 | 48 | 3 |
| | 6700 | 19 | 3 | 110 | 189 | 210 | 3 | 0 | 230 | 365 | 167 | 34 | 1 | 267 | 66 | 1 |
| 25% Quantil | 4467 | 14 | 2 | 129 | 132 | 105 | 2 | 0 | 205 | 318 | 131 | 13 | 1 | 140 | 40 | 1 |
| Median | 5625 | 18 | 3 | 160 | 156 | 127 | 3 | 1 | 215 | 363 | 156 | 20 | 2 | 183 | 47 | 2 |
| Mittelwert | 5833 | 16 | 3 | 163 | 153 | 135 | 3 | 1 | 208 | 342 | 150 | 26 | 2 | 184 | 46 | 2 |
| 75% Quantil | 7163 | 21 | 4 | 191 | 171 | 156 | 4 | 2 | 231 | 413 | 172 | 37 | 3 | 216 | 59 | 2 |

**Tabelle 6**

| **Zu Beispiel 3, Metallkontaminationen nach der Reinigung, Angaben in pptw** | | | | | | | | | | | | | | | | |
|---|---|---|---|---|---|---|---|---|---|---|---|---|---|---|---|---|
| | **Fe** | **Cr** | **Ni** | **Na** | **Zn** | **Al** | **Cu** | **Mo** | **Ti** | **W** | **K** | **Co** | **Mn** | **Ca** | **Mg** | **V** |
| | 12 | 2 | 1 | 2 | 0 | 1 | 1 | 0 | 12 | 1 | 1 | 0 | 0 | 12 | 0 | 0 |
| | 3 | 1 | 0 | 4 | 1 | 3 | 0 | 0 | 15 | 2 | 3 | 1 | 0 | 9 | 1 | 0 |
| | 2 | 0 | 1 | 7 | 3 | 2 | 1 | 1 | 5 | 0 | 1 | 2 | 1 | 3 | 1 | 1 |
| | 9 | 1 | 2 | 1 | 2 | 1 | 0 | 0 | 2 | 0 | 2 | 0 | 0 | 12 | 2 | 0 |
| | 8 | 2 | 0 | 3 | 1 | 0 | 2 | 0 | 5 | 1 | 1 | 0 | 2 | 6 | 0 | 0 |
| | 6 | 0 | 1 | 4 | 2 | 1 | 1 | 0 | 9 | 2 | 1 | 1 | 1 | 3 | 1 | 1 |
| | 4 | 1 | 2 | 2 | 1 | 2 | 1 | 0 | 12 | 2 | 3 | 0 | 1 | 1 | 2 | 0 |
| | 9 | 2 | 3 | 1 | 2 | 1 | 3 | 0 | 14 | 1 | 1 | 1 | 0 | 2 | 1 | 1 |
| 25% Quantil | 4 | 1 | 1 | 2 | 1 | 1 | 1 | 0 | 5 | 1 | 1 | 0 | 0 | 3 | 1 | 0 |
| Median | 7 | 1 | 1 | 3 | 2 | 1 | 1 | 0 | 11 | 1 | 1 | 1 | 1 | 5 | 1 | 0 |
| Mittelwert | 7 | 1 | 1 | 3 | 2 | 1 | 1 | 0 | 9 | 1 | 2 | 1 | 1 | 6 | 1 | 0 |
| 75% Quantil | 9 | 2 | 2 | 4 | 2 | 2 | 1 | 0 | 13 | 2 | 2 | 1 | 1 | 10 | 1 | 1 |

## Patentansprüche

1. Verfahren zur Herstellung von polykristallinen Siliciumbruchstücken, umfassend Bereitstellen eines polykristallinen Siliciumstabs, Zerkleinerung des polykristallinen Siliciumstabs in kubische Bruchstücke, Reinigung der polykristallinen Siliciumbruchstücke, **dadurch gekennzeichnet, dass** zur Zerkleinerung ein Stachelwalzenbrecher mit wenigstens einer Stachelwalze eingesetzt wird, wobei die wenigstens eine Stachelwalze auf W₂C-Phasen basiert.

2. Verfahren nach Anspruch 1, wobei die Reinigung der polykristallinen Siliciumbruchstücke folgende Schritte umfasst: Vorreinigung in HF, HCl und H₂O₂; Spülen mit Reinstwasser; Hauptreinigung mittels HF/HNO₃ in von Vorreinigung separatem Säurekreislauf; Spülen mit Reinstwasser; Hydrophilierung mit Ozonwasser; Trocknen mit Reinstluft; Abkühlen mit Reinstluft.

## Claims

1. Method for producing polycrystalline silicon chunks, comprising providing a polycrystalline silicon rod, comminuting the polycrystalline silicon rod into cubic chunks, and cleaning the polycrystalline silicon chunks, **characterized in that** comminution takes place using a spiked-roll crusher having at least one spiked roll, the at least one spiked roll being based on W₂C phases.

2. Method according to Claim 1, wherein the cleaning of the polycrystalline silicon chunks comprises the following steps: preliminary cleaning in HF, HCl, and H₂O₂; rinsing with ultrapure water; main cleaning by means of HF/HNO₃ in an acid circuit separate from the preliminary cleaning; rinsing with ultrapure water; hydrophilization with ozone water; drying with ultrapure air; cooling with ultrapure air.

## Revendications

1. Procédé de fabrication de fragments de silicium polycristallin, comprenant la préparation d'une baguette de silicium polycristallin, le broyage de la baguette de silicium polycristallin en fragments cubiques, la purification des fragments de silicium polycristallin, **caractérisé en ce qu'**un broyeur à cylindre à pointes comprenant au moins un cylindre à pointes est utilisé pour le broyage, ledit au moins un cylindre à pointes étant à base de phases W₂C.

2. Procédé selon la revendication 1, dans lequel la purification des fragments de silicium polycristallin comprend les étapes suivantes : la pré-purification dans HF, HCl et H₂O₂ ; le rinçage avec de l'eau ultra-pure ; la purification principale avec HF/HNO₃ dans un circuit d'acide séparé de la pré-purification ; le rinçage avec de l'eau ultra-pure ; l'hydrophilisation avec de l'eau ozonée ; le séchage avec de l'air ultra-pur ; le refroidissement avec de l'air ultra-pur.
